# EUROPÄISCHE PATENTSCHRIFT

(11) **EP 2 890 530 B1**
(45) Veröffentlichungstag und Bekanntmachung des Hinweises auf die Patenterteilung: **16.08.2017**
(21) Anmeldenummer: 13750711.7
(22) Anmeldetag: 21.08.2013
(51) Int. Cl.: B25J 15/00, B25J 15/06

(54) **GREIFVORRICHTUNG**
GRIPPER APPARATUS
DISPOSITIF DE PRÉHENSION

(30) Priorität: 31.08.2012 DE 102012215513
(43) Veröffentlichungstag der Anmeldung: 08.07.2015
(73) Patentinhaber: J. Schmalz GmbH, 72293 Glatten (DE)
(72) Erfinder: EISELE, Thomas, 72275 Alpirsbach-Peterzell (DE); DEFRANCESKI, Aline, 72160 Horb a.N. (DE)
(74) Vertreter: DREISS Patentanwälte PartG mbB
(86) Internationale Anmeldenummer: PCT/EP2013/067364
(87) Internationale Veröffentlichungsnummer: WO 2014/033021

(56) Entgegenhaltungen:
- EP-A2- 1 473 764
- WO-A2-2007/143662
- US-A1- 2011 193 362

## Beschreibung

Die Erfindung betrifft eine Greifvorrichtung nach dem Oberbegriff des Anspruchs 1.

Derartige Greifvorrichtungen nutzen das Prinzip der Elektroadhäsion, um eine Haltekraft auf einen zu greifenden oder zu haltenden Gegenstand auszuüben. Hierzu wird ein insbesondere statisches elektrisches Potential an wenigstens eine Elektrode einer elektroadhäsiven Greifeinrichtung angelegt. Dadurch wird ein insbesondere statisches elektrisches Feld erzeugt. Werden die Elektroden einer solchen elektroadhäsiven Greifeinrichtung nahe der Oberfläche eines zu greifenden Gegenstandes positioniert, so kann über das elektrische Feld eine Elektroadhäsionskraft von der Greifeinrichtung auf den zu greifenden Gegenstand ausgeübt werden.

Dabei besteht das Problem, dass der Wirkbereich der Elektroadhäsionskraft um die Elektrode nur eine sehr geringe Größe aufweist. Um einen Gegenstand zuverlässig greifen und halten zu können, darf daher der Abstand zwischen der Oberfläche des zu greifenden Gegenstandes und den Elektroden nur sehr gering sein. Im Stand der Technik sind daher hauptsächlich elektroadhäsive Greifvorrichtungen zur Handhabung von ebenen Bauteilen, beispielsweise Halbleiter-Wafern beschrieben.

Probleme bereitet insbesondere ein Greifen und Halten von unebenen Objekten. Aufgrund der geringen Reichweite der Elektroadhäsionskraft ist es außerdem problematisch, Gegenstände aufzunehmen, wenn die elektroadhäsive Greifvorrichtung nicht unmittelbar auf den zu greifenden Gegenstand aufgesetzt werden kann. Eine elektroadhäsive Greifvorrichtung weist insofern eine nur geringe Tiefenwirkung auf. Eine Sprunghöhe lässt sich nur schwer erzielen. Daher ist es auch problematisch, aus einer Mehrzahl nebeneinander angeordneter Gegenstände eine gezielte Auswahl oder nur einzelne Gegenstände aufzunehmen. Außerdem sind die beschriebenen Greifvorrichtungen nur begrenzt dazu geeignet, eine Vereinzelung von Gegenständen einer Ansammlung einer Vielzahl von Gegenständen vorzunehmen. Problematisch kann schließlich auch die Ablösung eines von der elektroadhäsiven Greifvorrichtung gehaltenen Objektes sein, da es z.B. bei nicht leitfähigen Gegenständen zu einer elektrostatischen Aufladung kommen kann.

In der US 2011/0110010 A1 und der WO 2007/143622 A2 ist eine elektroadhäsive Greifvorrichtung mit den Merkmalen des Oberbegriffs des Anspruchs 1 beschrieben, welche eine sich eben erstreckende, jedoch flexibel verbiegbare Greiffläche aufweist, in welche zur Ausübung einer Elektroadhäsionskraft Elektroabschnitte eingearbeitet sind.

In der DE 103 19 272 A1 ist ein Multifunktionsträger insbesondere für einen Greifer beschrieben. Der Multifunktionsträger weist ein ebenes, als Anlagefläche dienendes Trägersubstrat auf. In der Ebene des Trägersubstrats sind Elektroabschnitte zum Ausüben einer Elektroadhäsionskraft auf einen anliegenden Gegenstand vorgesehen. Außerdem sind in der Anlageebene Durchströmöffnungen für eine Bernoulli-Saugeinrichtung und für weitere Vakuum-Haltevorrichtungen vorgesehen. Der Multifunktionsträger dient dazu, flächige Werkstücke, wie beispielsweise Halbleiterscheiben, zu ihrer Handhabung zu fixieren, wobei zu einem gewissen Grade Krümmungen der flächigen Werkstücke ausgeglichen werden können. Hierzu wird das zu fixierende Werkstück mittels der Bernoulli-Saugeinrichtung mit einer vergleichsweise großen Saugkraft an die Anlagefläche angesaugt und in den Wirkungsbereich der Elektroden zur Ausübung einer Elektroadhäsionskraft gebracht. Größere Oberflächenunebenheiten können jedoch nicht ausgeglichen werden.

Der Erfindung liegt die Aufgabe zugrunde, eine Greifvorrichtung bereitzustellen, mittels welcher auch Gegenstände mit unebener Oberflächenkontur zuverlässig und sicher gegriffen und gehalten werden können. Insbesondere soll ein gezieltes Aufnehmen einzelner Gegenstände oder eine Vereinzelung von Gegenständen einer Ansammlung verschiedener Gegenstände möglich sein.

Diese Aufgabe wird durch eine Greifvorrichtung mit den Merkmalen des Anspruchs 1 gelöst. Diese umfasst eine Aufnahmefläche, welche zum Greifen eines zu greifenden Gegenstandes diesem zugewandt werden kann, sowie wenigstens einen Elektroadhäsionsabschnitt zur Ausübung einer Elektroadhäsionskraft auf den Gegenstand. Der Elektroadhäsionsabschnitt weist zumindest eine Elektrode zur Erzeugung eines elektrischen Feldes auf.

Es ist vorgesehen, dass der Elektroadhäsionsabschnitt zur Anlage an dem zu greifenden Gegenstand über die Aufnahmefläche in Richtung des zu greifenden Gegenstandes derart hervorsteht, dass ein an die Aufnahmefläche und an den Elektroadhäsionsabschnitt angrenzender Abstandsraum gebildet werden kann. Der Elektroadhäsionsabschnitt ist außerdem derart verformbar ausgebildet, dass er bei Anlage an dem zu greifenden Gegenstand beziehungsweise an dessen Oberflächenkontur formanpassbar ist.

Diese Ausgestaltung ermöglicht es, auch Gegenstände mit Oberflächenstrukturen oder unebene Gegenstände sicher an dem Elektroadhäsionsabschnitt zu halten. Der Elektroadhäsionsabschnitt ist insbesondere derart ausgebildet, dass er bei Anliegen an den Gegenstand in Richtung zur Aufnahmefläche hin komprimierbar ist. Hierzu ist es nicht erforderlich, dass die gesamte Greiffläche als flexibles Bauteil ausgebildet ist, wie dies bei dem eingangs genannten Stand der Technik der Fall ist. Die Aufnahmefläche der erfindungsgemäßen Greifvorrichtung muss nicht formanpassbar ausgebildet sein. Vielmehr kann die Aufnahmefläche starr ausgebildet sein, beispielsweise als Teil eines Gehäuses oder Trägerabschnitt der Greifvorrichtung. Dies ermöglicht einen stabilen und kompakten Aufbau der Greifvorrichtung.

Dadurch können Gegenstände gehalten werden, welche z.B. aufgrund ihrer Oberflächenbeschaffenheit nicht mit Sauggreifern gehalten werden können (zum Beispiel löchrige Oberflächen aufweisen) oder welche nicht magnetisch ausgebildet sind.

Die erfindungsgemäße Greifvorrichtung ermöglicht außerdem in vorteilhafter Weise die Integration zusätzlicher Greifprinzipien. Es ist zumindest eine weitere, von der Elektroadhäsion funktional unabhängige Greifeinrichtung vorgesehen. Diese ist an einem den Abstandsraum begrenzenden Abschnitt der Aufnahmefläche angeordnet. Hierzu ist ein insbesondere von der Elektroadhäsion funktional unabhängiges Greifmittel oder eine Greifeinrichtung zur Ausübung einer Greifkraft in den Abstandsraum integriert. Das Greifmittel oder die Greifeinrichtung ist im Abstandsraum an der Aufnahmefläche angeordnet, oder kann diese umfassen, wie nachfolgend noch beispielhaft erläutert. Die zusätzlichen Greifmittel oder Greifeinrichtungen ermöglichen es, mit der erfindungsgemäßen Greifvorrichtung größere Kräfte auszuüben, als dies mittels Elektroadhäsion alleine möglich wäre.

Ferner kann mit dem zusätzlichen Greifmittel oder der zusätzlichen Greifeinrichtung eine Kraft auf den zu greifenden Gegenstand ausgeübt werden, so dass dieser in engen Kontakt mit dem Elektroadhäsionsabschnitt gelangt und eine Verformung des Elektroadhäsionsabschnitts zur Anpassung an die Oberflächenstruktur des Gegenstandes erfolgt. Die Elastizität des Elektroadhäsionsabschnitts ist vorzugsweise auf die mit der zusätzlichen Greifeinrichtung ausübbare Haltekraft in Richtung der Aufnahmefläche abgestimmt, so dass eine Verformung und Anpassung des Elektroadhäsionsabschnitts erfolgt.

Wenn der Gegenstand an den Elektroadhäsionsabschnitt anliegt, kann eine große Elektroadhäsionskraft ausgeübt werden. Die Greifvorrichtung kann insbesondere derart ausgestaltet sein, dass nach Aufnahme des Gegenstandes ein Halten des Gegenstandes ausschließlich mittels der Elektroadhäsionskraft erfolgt, d.h. die eventuellen weiteren Greifmittel oder Greifeinrichtungen deaktiviert sind. Dies ermöglicht es, den so gehaltenen Gegenstand z.B. in eine Vakuumumgebung zu verbringen, in welcher ein Halten mittels Unterdruck nicht mehr möglich wäre. Außerdem kann durch eine Deaktivierung der weiteren Greifeinrichtung die Energieeffizienz erhöht werden und dennoch das Werkstück positionsgenau mittels der elektroadhäsiven Greifeinrichtung gehalten werden.

Die Aufnahmefläche ist insbesondere eben ausgebildet, beispielsweise in der Art einer Greiferplatte eines Flächengreifers. Denkbar ist jedoch auch ein gekrümmter Verlauf der Aufnahmefläche, beispielsweise als Kontaktfläche eines Sauggreifers.

Mittels des Elektroadhäsionsabschnitts kann nach den eingangs erläuterten Prinzipien eine Elektroadhäsive Kraft erzeugt werden. Der Elektroadhäsionsabschnitt ist formanpassbar insofern, als er sich an Konturen der Oberfläche des zu greifenden Gegenstands anpassen kann, um eine effektive Einleitung der Elektroadhäsionskraft zu ermöglichen. Der Elektroadhäsionsabschnitt ist insbesondere elastisch. Vorzugsweise ist er derart weich ausgebildet, dass ein Formschluss mit Abschnitten der Oberfläche des zu greifenden Gegenstandes erzielt werden kann. Denkbar ist z.B. eine Ausgestaltung aus einem Elastomer oder einem flexiblen, insbesondere elastischen, Schaum, beispielsweise Kunststoffschaum. Der Elektroadhäsionsabschnitt ist insbesondere gratartig oder leistenartig auf der Aufnahmefläche verlaufend ausgebildet.

Zur Erzeugung des elektrischen Feldes umfasst der verformbare Elektroadhäsionsabschnitt wenigstens eine Elektrode. Diese ist insbesondere selbst verformbar ausgebildet, beispielsweise als dünne Metallschicht. Die Elektrode kann auch durch ein Trägermaterial mit leitenden Partikeln, z.B. Carbon-Nano-Tubes, gebildet sein. Die leitenden Partikel können in das Trägermaterial eingebracht oder auf das Trägermaterial aufgebracht sein. Die Elektrode kann in den Elektroadhäsionsabschnitt eingebracht sein, d.h. in seinem Inneren verlaufen. Denkbar ist jedoch auch, dass die Elektrode auf einer dem zu greifenden Gegenstand zugewandten Oberfläche des Elektroadhäsionsabschnitts verläuft. Auf der Elektrode kann eine Isolierschicht aufgebracht sein.

Die weitere Greifeinrichtung ist insbesondere als Sauggreifer, Bernoulli-Greifer, Magnetgreifer, insbesondere mit ansteuerbarem Magnet, oder Nadelgreifer ausgebildet. Die weitere Greifeinrichtung ist derart ausgebildet, dass eine Haltekraft und/oder Greifkraft auf den zu greifenden Gegenstand in Richtung der Aufnahmefläche ausgeübt werden kann. Dies ermöglicht es, Gegenstände auch aus größerer Entfernung zur Aufnahmefläche anzuziehen. Mittels einer geeigneten weiteren Greifeinrichtung kann daher eine Sprunghöhe erzielt werden. Insbesondere ein Bernoulli-Greifer kann über große Tiefenwirkung verfügen.

Eine Kombination von elektroadhäsiver Greifeinrichtung und Magnetgreifeinrichtung mit ansteuerbarem Magnet ist z.B. vorteilhaft zur Handhabung von Blechen, insbesondere bei deren Zuschnitt. Mittels der Magnetgreifeinrichtung können ausgeschnittene Blechteile selektiv aus dem Restgitter entnommen werden und durch die magnetische Kraft an den Elektroadhäsionsabschnitt angedrückt werden. Wenn die elektroadhäsive Haltekraft wirksam ist, kann die Magnetgreifeinrichtung deaktiviert werden.

Bei Verwendung eines Vakuumgreifers als weitere Greifeinrichtung kann durch die Anpassung der Elektroadhäsionsabschnitte bei Anlage an den Gegenstand eine Leckage reduziert werden. Hierzu ist es besonders vorteilhaft, wenn der Elektroadhäsionsabschnitt derart weich ausgebildet ist, dass ein Formschluss zu Abschnitten der Oberfläche des zu greifenden Gegenstands erzielt werden kann.

Findet ein Nadelgreifer als weitere Greifeinrichtung Verwendung, so ist aufgrund der zusätzlich wirkenden Elektroadhäsionskraft eine verringerte Eindringtiefe der Nadeln erforderlich, was beispielsweise einen geringeren Bauraum für den Nadelgreifer erforderlich macht.

Ein Halten des Gegenstandes mittels der Elektroadhäsionsabschnitte ermöglicht in vorteilhafter Weise eine Detektion, ob ein Gegenstand mit der Greifvorrichtung aufgenommen wurde. Dem liegt der Effekt zugrunde, dass sich die elektrischen Eigenschaften des Elektroadhäsionsabschnitts ändern können, wenn ein Gegenstand an ihm anliegt. Insbesondere kann über die elektrischen Eigenschaften des Elektroadhäsionsabschnitts detektiert werden, ob eine eventuelle zusätzliche Greifeinrichtung der Greifvorrichtung einen Gegenstand gegriffen hat und diesen an den Elektroadhäsionsabschnitt zieht.

Der wenigstens eine Elektroadhäsionsabschnitt oder auch die einzelnen Elektroden eines Elektroadhäsionsabschnitts sind vorzugsweise elektrisch an- und ausschaltbar und/oder ansteuerbar, so dass die Greifwirkung aktivierbar und deaktivierbar ist bzw. die Größe der Elektroadhäsionskraft steuerbar ist. Hierzu kann die Greifvorrichtung eine Einrichtung zur Steuerung des elektrischen Potentials auf den Elektroden des Elektroadhäsionsabschnitts umfassen. Vorzugsweise sind verschiedene Elektroadhäsionsabschnitte und/oder verschiedene Elektroden eines Elektroadhäsionsabschnitts unabhängig voneinander an- und ausschaltbar oder elektrisch ansteuerbar. Diese Ausgestaltungen erlauben ein kontrolliertes Aufnehmen und Loslassen von Gegenständen.

Es kann auch eine Ablöseeinrichtung zum Ausüben einer Ablösekraft zum Ablösen eines gehaltenen Gegenstandes von dem

Elektroadhäsionsabschnitt vorgesehen sein. Die Ablöseeinrichtung ist z.B. in dem Abstandsraum oder an einem den Abstandsraum begrenzenden Abschnitt der Aufnahmefläche angeordnet. Denkbar ist jedoch auch, dass die Ablöseeinrichtung an dem Elektroadhäsionsabschnitt vorgesehen ist. Die Ablösekraft kann beispielsweise mechanisch mittels eines verlagerbaren Stößels ausgeübt werden. Vorzugsweise ist dieser in Richtung senkrecht zur Aufnahmefläche aus- und einfahrbar und insbesondere im Abstandsraum angeordnet. Das Ablösen kann jedoch auch durch Abblasen erfolgen. Hierzu kann die Ablöseeinrichtung wenigstens eine Abblasöffnung umfassen, welche insbesondere in der Aufnahmefläche, vorzugsweise in dem Abstandsraum angeordnet ist.

Der Elektroadhäsionsabschnitt kann den Abstandsraum in Richtungen entlang der Aufnahmefläche vollständig umschließen, z.B. derart, dass ein ringartig oder rechteckig begrenzter Abstandsraum definiert ist. Dadurch kann ein durch den Elektroadhäsionsabschnitt gegen eine Oberfläche des zu greifenden Gegenstands abdichtbarer Abstandsraum bereitgestellt werden.

Andererseits kann es vorteilhaft sein, wenn der Elektroadhäsionsabschnitt den Abstandsraum nicht vollumfänglich begrenzt. Beispielsweise können mehrere ineinander greifende Elektroadhäsionsabschnitte vorgesehen sein, welche sich insbesondere winkelig auf der Aufnahmefläche erstrecken.

Eine bevorzugte Ausführungsform der Erfindung ergibt sich dadurch, dass die Aufnahmefläche an einem insbesondere elastischen Saugkörper eines Sauggreifers angeordnet ist. Der Saugkörper begrenzt mit seiner Aufnahmefläche bei Anlage an den zu greifenden Gegenstand einen evakuierbaren Saugraum. Der Saugkörper ist z.B. glockenähnlich ausgebildet. Der Saugraum ist mit einer Unterdruckführung, z.B. einem Vakuumkanal, strömungsverbunden. Die Unterdruckführung erstreckt sich z.B. durch den Saugkörper in die von der Aufnahmefläche abgewandte Richtung und mündet beispielsweise in einen Unterdruckanschluss der Greifvorrichtung.

Der Elektroadhäsionsabschnitt kann dann als Dichtlippe zur dichtenden Anlage gegen einen zu greifenden Gegenstand ausgebildet sein.

Um einen an die Oberfläche eines Gegenstands anpassbaren Elektroadhäsionsabschnitt zu realisieren, kann der Elektroadhäsionsabschnitt einen von verformbaren Wandungen umschlossenen Füllraum umfassen. Der Füllraum ist insbesondere mit einem Granulat, einer elektrorheologischen Flüssigkeit oder einer magnetorhelogischen Flüssigkeit befüllt. Denkbar ist jedoch auch eine Befüllung mit einem Gas, z.B. Luft.

Zur weiteren Ausgestaltung kann die Greifvorrichtung eine Einrichtung aufweisen, um die Füllung des genannten Füllraumes zu verfestigen. Beispielsweise kann ein mit Granulat befüllter Füllraum evakuierbar ausgebildet sein, wozu eine steuerbare Evakuierungseinrichtung für den Füllraum vorgesehen sein kann. Bei Evakuierung wird die Luft zwischen der granularen Materie entfernt und die Füllung dadurch verfestigt. Ist der Füllraum beispielsweise mit einem elektrorheologischen bzw. magnetorheologischen Fluid befüllt, so kann eine Einrichtung zur Einbringung eines elektrischen bzw. magnetischen Feldes in das Fluid vorgesehen sein. Dadurch kann das elektrorheologische Fluid bzw. das magnetorheologische Fluid in bekannter Weise verfestigt werden.

Eine komfortable Reparatur oder Wartung der Greifvorrichtung wird dadurch ermöglicht, dass der wenigstens eine Elektroadhäsionsabschnitt derart an der Aufnahmefläche angeordnet ist, dass er befestigt und wieder gelöst werden kann. Dadurch ist ein Austausch des Elektroadhäsionsabschnitts möglich, wenn sich z.B. die elastischen Eigenschaften des Materials des Elektroadhäsionsabschnitts durch Alterung verändern. Bei einer Unterbrechung der Kontaktierung der Elektroden oder einzelner Abschnitte kann auf einfache Weise der Elektroadhäsionsabschnitt ausgewechselt werden.

Die Greifvorrichtung weist vorzugsweise eine Mehrzahl von separaten Elektroadhäsionsabschnitten auf, welche unabhängig voneinander zur Ausübung einer Elektroadhäsionskraft aktivierbar und deaktivierbar sind, das heißt unabhängig voneinander mit einem elektrischen Potential beaufschlagt werden können. Dies ermöglicht eine gezielte Aufnahme und ein gezieltes Loslassen einzelner Gegenstände.

Vorzugsweise sind die mehreren Elektroadhäsionsabschnitte derart angeordnet, dass die Aufnahmefläche in mehrere Haltezonen unterteilt ist. Jeder Haltezone ist dabei vorzugsweise ein Abstandsraum zugeordnet, welcher an wenigstens einen der jeweiligen Haltezone zugeordneten Elektroadhäsionsabschnitt angrenzt. Mit einer derartigen Greifvorrichtung können Gegenstände vereinzelt werden. Vorzugsweise weist jede Haltezonen eine zugeordnete weitere Greifeinrichtung wie oben beschrieben auf. Vorzugsweise sind die Greifeinrichtungen der verschiedenen Haltezonen wiederum unabhängig voneinander zum Greifen eines Gegenstandes aktivierbar und deaktivierbar. Die einzelnen Greifeinrichtungen sind vorzugsweise in dem jeweils zugeordneten Abstandsraum angeordnet, wie vorstehend erläutert.

Sind z.B. verschiedenen Abstandsräumen verschiedene, insbesondere unabhängig ansteuerbare, Magnetgreifeinrichtungen zugeordnet, so können z.B. verschiedene ausgeschnittene Blechteile selektiv aus dem Restgitter entnommen werden. Denkbar ist, dass die Aufnahmefläche so groß ist, dass sie beim Einsatz in einer Blechschneideanlage an ein Blech anlegbar ist, in welchem eine Mehrzahl von Blechteilen ausgeschnitten ist. Wenn die verschiedenen Haltezonen und/oder die verschiedenen zugeordneten Magnetgreifeinrichtungen unabhängig voneinander ansteuerbar bzw. aktivierbar und deaktivierbar ausgebildet sind, dann können die jeweils an einer Haltezone anliegenden Blechteile gezielt und unabhängig von anderen Blechteilen gegriffen, gehalten und separat abgelegt werden. In dem Restgitter innenliegende Blechteile oder Reststücke, die z.B. beim Schneiden eines Ringes entstehen, können so gezielt von den übrigen Teilen getrennt werden. Bei geeigneter Ausgestaltung der Haltezonen lassen sich so auch sehr kleine Bleche und Blechteile greifen und vereinzeln.

Bei sämtlichen Ausgestaltungen der erfindungsgemäßen Greifvorrichtung können verschiedene Elektroadhäsionsabschnitte mit voneinander abweichenden, elektrischen Potentialen belegt werden. Denkbar ist insbesondere, dass jeweils benachbarte Elektroadhäsionsabschnitte gegenpolig aufgeladen sind. Insbesondere kann jeder Elektroadhäsionsabschnitt eine Mehrzahl von Elektroden aufweisen, welche untereinander verschiedene Potentiale aufweisen können. Vorzugsweise weisen benachbarte Elektroadhäsionsabschnitte oder benachbarte Elektroden eines Elektroadhäsionsabschnittes gegenpolige Potentiale auf (bipolare oder multipolare Ausgestaltung). Denkbar ist jedoch auch eine unipolare Ausgestaltung, insbesondere mit gleichem Potential. Zwischen jeweils benachbarten Elektroadhäsionsabschnitten wird vorzugsweise eine Spannung angelegt. Die Spannung kann über Zeitabschnitte jeweils statisch angelegt werden. Denkbar ist jedoch auch die Verwendung einer alternierenden Spannung.

Zur weiteren Ausgestaltung kann die Greifvorrichtung derart ausgestaltet sein, dass durch wenigstens eine Elektrode eines Elektroadhäsionsabschnitts ein steuerbarer Strom geleitet werden kann. Hierzu weist die Greifvorrichtung insbesondere eine Stromführungseinrichtung auf, z.B. Verdrahtung für die Elektrode und ein Steuergerät, mit dem eine steuerbare Stromversorgung bereitgestellt werden kann.

Dadurch kann ein Magnetfeld variierbarer Größe und Polung erzielt werden. Dies kann dazu dienen, eine ergänzende Haltekraft beispielsweise auf magnetische oder magnetisierbare Gegenstände auszuüben. Umgekehrt kann das variierbare Magnetfeld dazu eingesetzt werden, einen magnetischen Gegenstand gezielt abzustoßen und so ein Ablösen von den Elektroadhäsionsabschnitten zu erzielen. Die Greifvorrichtung kann insbesondere eine elektronische Steuereinrichtung zum Anlegen eines zeitlich veränderlichen Potentials und zur Erzeugung eines zeitlich veränderlichen Stromflusses durch wenigstens eine Elektrode eines Elektroadhäsionsabschnitts aufweisen, so dass ein elektromagnetisches Wechselfeld erzeugt werden kann.

Die Elektroden können auch derart ausgebildet sein, dass mittels eines steuerbaren Stroms durch wenigstens eine der Elektroden eine gezielte Erwärmung der Elektrode und des Elektroadhäsionsabschnitts erzielt werden kann. Dies ist vorteilhaft, wenn gehaltene Teile erwärmt werden sollen oder eine Handhabung in warmem Zustand erfolgen soll. Dies kann z.B. bei der Handhabung von textilen Halbzeugen erwünscht sein, wo die Prozesszeit für Bearbeitungen durch Aufschmelzen des Binders während der Handhabung verringert werden kann. Die genannte Ausgestaltung ist auch vorteilhaft bei der Handhabung von sogenannten Organoblechen, welche nur in erwärmten Zustand (insbesondere mehrere Kelvin über Raumtemperatur) verformbar sind, und bei denen daher eine Abkühlung während des Bearbeitungsprozesses und insbesondere während der Handhabung vermieden werden soll.

Zur Lösung der eingangs gestellten Aufgabe können auch mehrere der beschriebenen Greifvorrichtungen in ein Greifsystem integriert werden. Die verschiedenen Greifvorrichtungen sind dann vorzugsweise derart angeordnet, dass die verschiedenen Aufnahmeflächen in einer gedachten Ebene liegen. Um ein flexibles Greifen zu ermöglichen, kann jedoch auch eine Anordnung der verschiedenen Aufnahmeflächen in voneinander abweichenden Ebenen vorteilhaft sein. Vorteilhaft kann es insbesondere sein, wenn die verschiedenen Greifvorrichtungen voneinander unabhängig bewegbar angeordnet sind.

Weitere Einzelheiten und vorteilhafte Ausgestaltungen der Erfindung sind der nachfolgenden Beschreibung zu entnehmen, anhand derer die in den Figuren dargestellten Ausführungsformen der Erfindung näher beschrieben und erläutert sind.

Es zeigen:
Fig. 1 und
Fig. 2 Skizzen zur Erläuterung einer ersten erfindungsgemäßen Greifvorrichtung in unipolarer Ausgestaltung;
Fig. 3 und
Fig. 4 Skizzen zur Erläuterung einer weiteren erfindungsgemäßen Greifvorrichtung in bipolarer Ausführung;
Fig. 5 und
Figur 6 Skizzen zur Erläuterung einer wiederum weiteren Ausführungsform zur Vereinzelung von Gegenständen;
Figur 7 eine erfindungsgemäße Greifvorrichtung;
Figur 8 eine weitere Ausführungsform einer erfindungsgemäßen Greifvorrichtung;
Fig. 9 und
Figur 10 eine erfindungsgemäße Greifvorrichtung mit Sauggreifer;
Figur 11 eine erfindungsgemäße Greifvorrichtung mit Nadelgreifer.

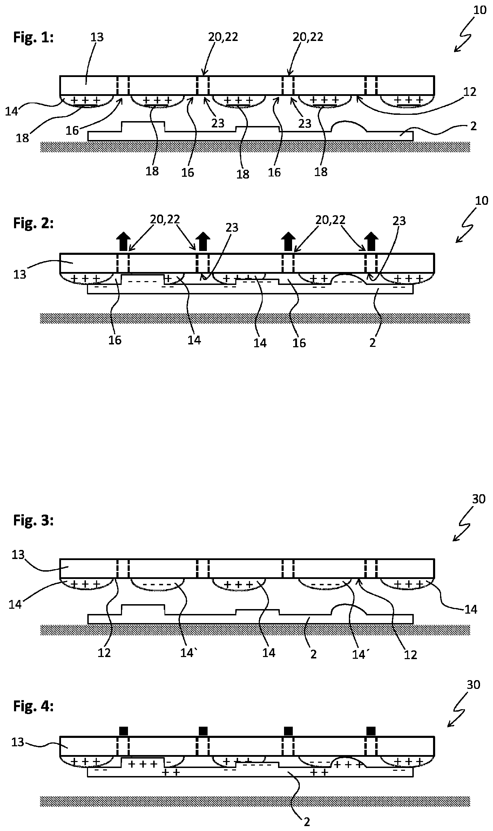

In der nachfolgenden Beschreibung sind für gleiche oder einander entsprechende Bauteile dieselben Bezugszeichen verwendet. In den Figuren 1 und 2 ist schematisch eine Greifvorrichtung 10 zum Halten und Greifen eines Gegenstands 2 dargestellt. Der Gegenstand 2 weist eine unebene Oberflächenkontur auf.

Die Greifvorrichtung 10 umfasst eine Aufnahmefläche 12, welche zum Greifen des Gegenstands 2 diesem zugewandt wird. Die Figuren 1 und 2 (ebenso die Figuren 3 bis 6) zeigen die Greifvorrichtung in einer Schnittdarstellung senkrecht zur Aufnahmefläche 12. Die Aufnahmefläche 12 ist vorzugsweise an einem Trägerabschnitt 13 der Greifvorrichtung 10 angeordnet. Im dargestellten Beispiel ist die Aufnahmefläche 12 eben ausgestaltet.

An der Aufnahmefläche 12 sind mehrere Elektroadhäsionsabschnitte 14 vorgesehen. Diese dienen zur Anlage an den zu greifenden Gegenstand 2 und stehen über die Aufnahmefläche 12 in Richtung des zu greifenden Gegenstands 2 derart hervor, dass jeweils ein von einem Abschnitt der Aufnahmefläche 12 und wenigstens einem Elektroadhäsionsabschnitt 14 begrenzter Abstandsraum 16 gebildet wird.

Jeder Elektroadhäsionsabschnitt 14 ist in bekannter Weise zur Ausübung einer Elektroadhäsionskraft auf dem Gegenstand 2 ausgebildet. Hierzu umfasst jeder Elektroadhäsionsabschnitt 14 zumindest eine Elektrode 18, mittels welcher ein elektrisches, insbesondere elektrostatisches Feld, erzeugt werden kann. Die Elektrode 18 ist vorzugsweise in einem dem Gegenstand 2 zugewandten Abschnitt des Elektroadhäsionsabschnitts 14 eingebettet. Sie kann jedoch auch auf eine insbesondere dem zu greifenden Gegenstand 2 zugewandte Oberfläche des Elektroadhäsionsabschnitts 14 aufgebracht sein und beispielsweise mit einer Isolierschicht bedeckt sein.

Jeder Elektroadhäsionsabschnitt 14 und insbesondere auch die von diesem umfasste Elektrode 18 ist verformbar ausgebildet. Dadurch kann sich der jeweilige Elektroadhäsionsabschnitt 14 bei Anlage an den Gegenstand 2 an dessen Oberflächenkontur anpassen, wie dies in Figur 2 dargestellt ist.

Die Greifvorrichtung 10 weist außerdem eine Mehrzahl von weiteren Greifeinrichtungen 20 auf, welche funktional von den Elektroadhäsionsabschnitten 14 unabhängig sind. Die weiteren Greifeinrichtungen 20 sind im dargestellten Beispiel als Sauggreifer 22 ausgebildet, welche jeweils eine in einen Abstandsraum 16 in der Aufnahmefläche 12 mündende Saugöffnung 23 aufweisen. Bei geeigneter Ausgestaltung der Elektroadhäsionsabschnitte 14 kann daher jeder Abstandsraum 16 als Saugraum des jeweiligen Sauggreifers 22 dienen, welcher durch die Saugöffnung 23 evakuierbar ist. Der so gebildete Saugraum kann dann durch die jeweils angrenzenden Elektroadhäsionsabschnitte 14 abgedichtet werden, wenn diese an dem zu greifenden Gegenstand 2 anliegen. Ein dichtendes Anliegen wird insbesondere dadurch erreicht, dass sich die Elektroadhäsionsabschnitte 14 der Oberflächenkontur des Gegenstands 2 anpassen können (vergleiche Figur 2).

Mit der Greifvorrichtung 10 kann der Gegenstand 2 zuverlässig und sicher gehalten werden. Einerseits ist es möglich, die Greifvorrichtung 10 dem Gegenstand 2 anzunähern und die Aufnahmefläche 12 derart in Richtung des Gegenstands 2 zu drücken, dass die Elektroadhäsionsabschnitte 14 an dem Gegenstand 2 anliegen und sich durch Verformung an die Oberflächenkontur des Gegenstands 2 anpassen. Dadurch ist der Abstand zwischen den felderzeugenden Elektroden 18 und dem Gegenstand 2 so gering, dass eine große Elektroadhäsionskraft erzeugt wird.

Es ist jedoch auch möglich, dass der Gegenstand 2 ausgehend von der in Figur 1 dargestellten Lage zunächst mittels der Sauggreifer 22 in Richtung der Aufnahmefläche 12 angesaugt wird und an den Elektroadhäsionsabschnitten 14 zum Anliegen kommt. Durch das Anliegen an den Elektroadhäsionsabschnitten 14 und die mögliche Formanpassung der Elektroadhäsionsabschnitte 14 an die Oberfläche des Gegenstands 2 kann dann die Elektroadhäsionskraft groß genug werden, um den Gegenstand 2 ausschließlich mittels der Elektroadhäsionsabschnitte 14 zu halten. Es ist dann möglich, die weitere Greifeinrichtung 20 zu deaktivieren.

Die zwischen den Elektroadhäsionsabschnitten 14 und dem Gegenstand 2 wirkende Elektroadhäsionskraft kann auch dazu dienen, eine engere Anlage des Elektroadhäsionsabschnitts 14 an die Oberfläche 2 und damit eine verbesserte Abdichtung des Abstandsraumes 16 an der Oberfläche des Gegenstands 2 zu erzielen. Dies ermöglicht es, mittels der Sauggreifer 22 eine große Saugkraft durch Evakuierung des jeweiligen Abstandsraums 16 auszuüben. Die Elektroadhäsionsabschnitte 14 dienen insofern als Dichtlippen für einen Saugraum eines Sauggreifers 22. Die eigentliche Haltekraft auf dem Gegenstand 2 wird dann nicht über die Elektroadhäsionskraft, sondern über den Unterdruck im jeweiligen Abstandsraum 16 aufgebracht.

In den Figuren 1 und 2 ist eine unipolare Ausführung der Elektroadhäsionskraft skizziert. Sämtliche Elektroadhäsionsabschnitte 14 sind mit einem positiven elektrostatischen Potential verbunden.

Für manche Anwendungen kann es vorteilhaft sein, die Elektroadhäsionskraft in einer bipolaren Ausführung zu realisieren, wobei die Aufnahmefläche 12 einerseits Elektroadhäsionsabschnitte 14 aufweist, welche mit einem positiven elektrischen Potential verbunden sind. Andererseits sind Elektroadhäsionsabschnitte 14' vorgesehen, welche mit einem hiervon abweichenden, insbesondere geringerem elektrischen Potential beaufschlagt sind.

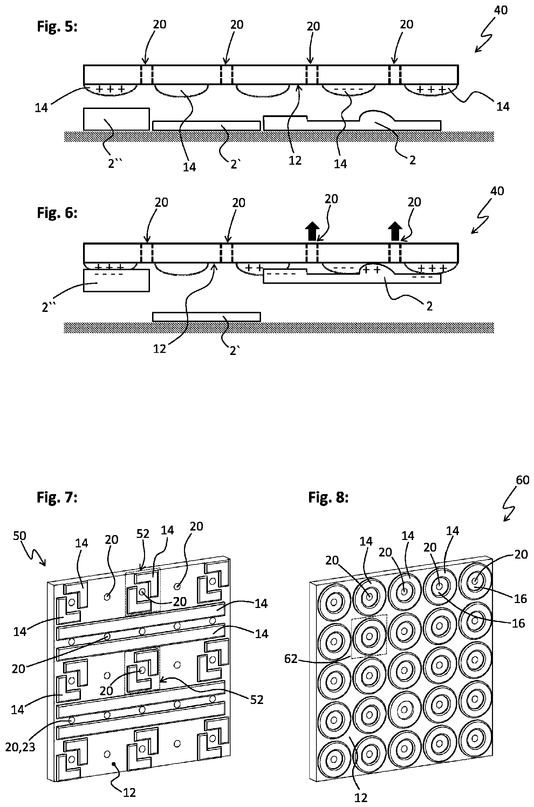

Die in den Figuren 5 und 6 skizzierte Greifvorrichtung 40 ist im Wesentlichen entsprechend der Greifvorrichtungen 10 und 30 ausgestaltet. Dabei sind jedoch die verschiedenen Elektroadhäsionsabschnitte 14 unabhängig voneinander zur Ausübung einer Elektroadhäsionskraft aktivierbar und deaktivierbar. Hierfür weist die Greifvorrichtung 40 eine nicht näher dargestellte elektrische Steuereinrichtung auf. Bei der Greifvorrichtung 40 sind die weiteren Greifeinrichtungen 20 (Sauggreifer 22) ebenfalls unabhängig voneinander zur Ausübung einer Greifkraft beziehungsweise Haltekraft auf dem Gegenstand 2 aktivierbar und deaktivierbar. Dies ermöglicht es, mit der Greifvorrichtung 40 einzelne Gegenstände einer Ansammlung von in den Figuren 5 und 6 mit 2, 2' und 2" bezeichneten Gegenständen isoliert zu greifen. Die Greifvorrichtung 40 kann damit zur Vereinzelung von Gegenständen eingesetzt werden.

In der Figur 7 ist eine als Flächengreifer ausgeführte erfindungsgemäße Greifvorrichtung 15 in einer Aufsicht auf die Aufnahmefläche 12 dargestellt.

Die Greifvorrichtung 50 umfasst eine Mehrzahl von separat ausgebildeten Elektroadhäsionsabschnitten 14, welche in der vorstehend erläuterten Art über die Aufnahmefläche 12 hervorstehen. Die Elektroadhäsionsabschnitte 14 verlaufen teilweise geradlinig langgestreckt auf der Aufnahmefläche 12. Außerdem sind Elektroadhäsionsabschnitte 14 vorgesehen, welche sich winkelig, L-förmig auf der Aufnahmefläche 12 erstrecken. An der Aufnahmefläche 12 sind wiederum weitere Greifeinrichtungen 20 angeordnet, welche z.B. als Sauggreifer mit in der Aufnahmefläche 12 mündenden Saugöffnungen 23 ausgebildet sein können. Auf der Aufnahmefläche 12 werden mehrere Haltezonen 52 durch je zwei L-förmige Elektroadhäsionsabschnitte 14 definiert, die sich bezüglich einer weiteren Greifeinrichtung 20 gegenüberliegen.

In der Figur 8 ist eine erfindungsgemäße Greifvorrichtung 60 wiederum in einer Darstellung mit Blick auf die Aufnahmefläche 12 dargestellt. Die Greifvorrichtung 60 weist eine Vielzahl identisch ausgebildeter, ringförmiger Elektroadhäsionsabschnitte 14 auf. Jeder der ringförmigen Elektroadhäsionsabschnitte 14 umschließt einen Abstandsraum 16 vollständig in Richtungen entlang der ebenen Aufnahmefläche 12. In jedem so umschlossenen Abstandsraum 16 ist eine weitere Greifeinrichtung 20 (z.B. Sauggreifer) an der Aufnahmefläche 12 angeordnet.

Durch je einen ringförmigen Elektroadhäsionsabschnitt 14 ist auf der Aufnahmefläche 12 eine Haltezone 62 definiert. Die Elektroadhäsionsabschnitte 14 sind derart matrixartig auf der Aufnahmefläche 12 angeordnet, dass diese in matrixartig angeordnete Haltezonen 62 unterteilt ist. Vorzugsweise sind die Elektroadhäsionsabschnitte 14 und die weiteren Greifeinrichtungen 20 für jede Haltezone 52 beziehungsweise 62 unabhängig aktivierbar und deaktivierbar.

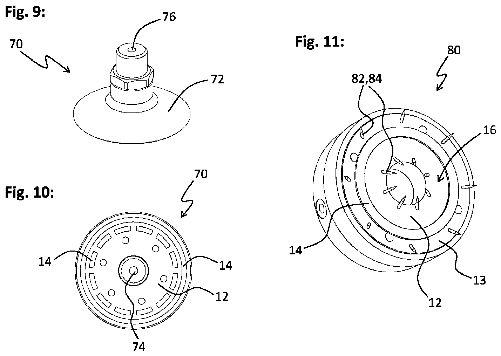

Anhand der Figuren 9 und 10 wird eine erfindungsgemäße Greifvorrichtung 70 erläutert, die als Ganzes in der Art eines Sauggreifers ausgebildet ist. Die Greifvorrichtung 17 umfasst einen glockenartig ausgebildeten, flexiblen Saugkörper 72. Der Saugkörper 72 ist derart ausgebildet, dass er an einem zu greifenden Gegenstand anliegen kann und mit diesem einen Saugraum begrenzt, welcher zur Aufnahme des Gegenstandes evakuierbar ist. Hierzu ist der so gebildete Saugraum über eine Unterdruckführung 74 (vergleiche Figur 10), welche sich durch den Saugkörper 72 erstreckt, mit einem Unterdruckanschluss 76 (vergleiche Figur 9) strömungsverbunden.

Bei der Greifvorrichtung 70 bildet die den Saugraum begrenzende Oberfläche des Saugkörpers 72 die Aufnahmefläche 12 der Greifvorrichtung 70. Figur 10 zeigt die Greifvorrichtung 70 in einer Darstellung mit Blick auf die Aufnahmefläche 12. Im Falle der Greifvorrichtung 70 ist die Aufnahmefläche 12 nicht eben, sondern glockenartig gewölbt. An der Aufnahmefläche 12 sind wiederum elastisch verformbare Elektroadhäsionsabschnitte 14 angeordnet, welche über die Aufnahmefläche 12 in Richtung des zu greifenden Gegenstandes hervorragen. Vorteilhaft ist es insbesondere, wenn ein Elektroadhäsionsabschnitt 14 ringartig entlang des radialen Randbereiches der glockenartigen Aufnahmefläche 12 des Saugkörpers 72 verläuft. Dadurch kann eine verbesserte Abdichtung des Saugraums erzielt werden.

Die Figur 11 zeigt eine Greifvorrichtung 80. Diese weist eine von einem starren Trägerabschnitt 13 gebildete, ebene Aufnahmefläche 12 auf. Diese weist Durchbrüche auf, durch welche in an sich bekannter Art und Weise Greifnadeln 82 einer Nadelgreifeinrichtung 84 über die Aufnahmefläche 12 hinaus und wieder zurück verlagert werden können. An der Aufnahmefläche 12 ist ein im dargestellten Beispiel ringförmiger, elastisch verformbarer Elektroadhäsionsabschnitt 14 angeordnet. Dieser umschließt einen Abstandsraum 16, in welchem Greifnadeln 82 angeordnet sind. Bei der Greifeinrichtung 80 sind außerdem weitere bewegliche Greifnadeln 82 der Nadelgreifeinrichtung 84 im radial außerhalb des Abstandsraumes 16 liegenden Bereich der Aufnahmefläche 12 vorgesehen.

## Patentansprüche

1. Greifvorrichtung (10, 30, 40, 50, 60, 70, 80) zum Greifen und Halten von Gegenständen (2), umfassend eine Aufnahmefläche (12), die zum Greifen einem Gegenstand (2) zugewandt ist, und eine elektroadhäsive Greifeinrichtung mit wenigstens einem, zumindest eine Elektrode (18) aufweisenden Elektroadhäsionsabschnitt (14, 14') zur Ausübung einer Elektroadhäsionskraft auf den Gegenstand (2), wobei der Elektroadhäsionsabschnitt (14, 14') zur Anlage an den zu greifenden Gegenstand (2) über die Aufnahmefläche (12) in Richtung des zu greifenden Gegenstandes derart hervorsteht, dass ein an die Aufnahmefläche (12) und an den Elektroadhäsionsabschnitt (14, 14') angrenzender Abstandsraum (16) gebildet ist, und dass der Elektroadhäsionsabschnitt (14, 14') derart verformbar ausgebildet ist, dass er bei Anlage an den zu greifenden Gegenstand (2) an diesen formanpassbar ist, **dadurch gekennzeichnet, dass** wenigstens eine andere, von der Elektroadhäsion unabhängige Greifeinrichtung (20) vorgesehen ist, welche an einem den Abstandsraum (16) begrenzenden Abschnitt der Aufnahmefläche (12) angeordnet ist.

2. Greifvorrichtung (10, 30, 40, 50, 60, 70, 80) nach Anspruch 1, **dadurch gekennzeichnet, dass** die andere Greifeinrichtung (20) als Sauggreifer (22), Bernoulli-Greifer, Magnetgreifer oder Nadelgreifer (84) ausgebildet ist.

3. Greifvorrichtung nach Anspruch 1 oder 2, **dadurch gekennzeichnet, dass** eine Ablöseeinrichtung zum Ausüben einer Ablösekraft zum Ablösen eines gehaltenen Gegenstandes (2) von dem Elektroadhäsionsabschnitt (14) vorgesehen ist, wobei die Ablöseeinrichtung insbesondere an einem den Abstandsraum (16) begrenzenden Abschnitt der Aufnahmefläche (12) angeordnet ist.

4. Greifvorrichtung (60, 70, 80) nach einem der vorhergehenden Ansprüche, **dadurch gekennzeichnet, dass** der Elektroadhäsionsabschnitt (14, 14') den Abstandsraum (16) in Richtungen entlang der Aufnahmefläche (12) vollständig umschließt.

5. Greifvorrichtung (70) nach einem der vorhergehenden Ansprüche, **dadurch gekennzeichnet, dass** die Aufnahmefläche (12) an einem Saugkörper (72) eines Saugreifers angeordnet ist.

6. Greifvorrichtung (70) nach dem vorhergehenden Anspruch, **dadurch gekennzeichnet, dass** der Elektroadhäsionsabschnitt (14, 14') als Dichtlippe derart ausgebildet ist, dass ein Saugraum des Saugkörpers (72) bei anliegendem Gegenstand abdichtbar ist.

7. Greifvorrichtung nach einem der vorhergehenden Ansprüche, **dadurch gekennzeichnet, dass** der Elektroadhäsionsabschnitt (14) einen von verformbaren Wandungen umschlossenen Füllraum umfasst, welcher mit einem Granulat, einem elektrorheologischen Fluid oder einem magnetorheologischen Fluid befüllt ist.

8. Greifvorrichtung nach einem der vorhergehenden Ansprüche, **dadurch gekennzeichnet, dass** der wenigstens eine Elektroadhäsionsabschnitt (14) lösbar befestigbar an der Aufnahmefläche (12) angeordnet ist.

9. Greifvorrichtung (30, 50, 60) nach einem der vorhergehenden Ansprüche, **dadurch gekennzeichnet, dass** eine Mehrzahl von separaten Elektroadhäsionsabschnitten (14, 14') vorgesehen ist, welche unabhängig voneinander zur Ausübung einer Elektroadhäsionskraft aktivierbar und deaktivierbar sind.

10. Greifvorrichtung (50, 60) nach dem vorhergehenden Anspruch, **dadurch gekennzeichnet, dass** die mehreren Elektroadhäsionsabschnitte (14) derart angeordnet sind, dass die Aufnahmefläche (12) in mehrere Haltezonen (52, 62) unterteilt ist, wobei jeder Haltezone (52, 62) ein Abstandsraum (16) zugeordnet ist, welcher an wenigstens einen der jeweiligen Haltezone (52, 62) zugeordneten Elektroadhäsionsabschnitt (14) angrenzt.

11. Greifvorrichtung nach einem der vorherigen Ansprüche, **dadurch gekennzeichnet, dass** die Greifvorrichtung derart ausgebildet ist, dass durch wenigstens eine Elektrode eines Elektroadhäsionsabschnitts ein steuerbarer Strom geleitet werden kann.

12. Greifvorrichtung nach Anspruch 11, **dadurch gekennzeichnet, dass** wenigstens ein Elektroadhäsionsabschnitt derart ausgebildet ist, dass mittels des durch die zugeordnete Elektrode leitbaren, steuerbaren Stromes der zugeordnete Elektroadhäsionsabschnitt erwärmbar ist.

## Claims

1. Gripper apparatus (10, 30, 40, 50, 60, 70, 80) for gripping and holding objects (2), comprising a mounting surface (12) which is oriented to face an object (2) which is to be gripped and an electroadhesive gripper device comprising at least one electroadhesive section (14,14') with at least one electrode (18) for exercising an electroadhesive force on the object (2), wherein in order to make contact with the object which is to be gripped (2) the electroadhesive section (14,14') projects beyond the mounting surface (12) in the direction of the object which is to be gripped such that a spacing gap (16) is formed adjoining the mounting surface (12) and the electroadhesive section (14, 14') and the electroadhesive section (14, 14') is designed to be deformable such that on coming into contact with the object which is to be gripped (2) it is adaptable in form thereto, **characterised in that** at least one other gripper device (20) independent of the electroadhesion is provided which is arranged on a section of the mounting surface (12) adjoining the spacing gap (16).

2. Gripper apparatus (10, 30, 40, 50, 60, 70, 80) according to claim 1, **characterised in that** the other gripper device (20) is designed as a suction gripper (22), Bernoulli gripper, magnetic gripper or needle gripper (84).

3. Gripper apparatus according to claim 1 or 2, **characterised in that** a detaching device is provided in order to exert a detaching force in order to detach a held object (2) from the electroadhesive section (14), wherein the detaching device is in particular arranged on a section of the mounting surface (12) adjoining the spacing gap (16).

4. Gripper apparatus (60, 70, 80) according to one of the preceding claims, **characterised in that** the electroadhesive section (14,14') completely surrounds the spacing gap (16) in directions along the mounting surface (12).

5. Gripper apparatus (70) according to one of the preceding claims, **characterised in that** the mounting surface (12) is arranged on a suction body (72) of a suction gripper.

6. Gripper apparatus (70) according to the preceding claim, **characterised in that** the electroadhesive section (14,14') is designed as a sealing lip such that a suction space of the suction body (72) can be sealed when in contact with an object.

7. Gripper apparatus according to one of the preceding claims, **characterised in that** the electroadhesive section (14) comprises a filling space surrounded by deformable walls which is filled with a granulate, an electrorheological fluid or a magnetorheological fluid.

8. Gripper apparatus according to one of the preceding claims, **characterised in that** the at least one electroadhesive section (14) is arranged on the mounting surface (12) in a detachably attachable manner.

9. Gripper apparatus (30, 50, 60) according to one of the preceding claims, **characterised in that** a plurality of separate electroadhesive sections (14,14') are provided which can be activated and deactivated independently of one another in order to exert an electroadhesive force.

10. Gripper apparatus (50, 60) according to the preceding claim, **characterised in that** the plurality of electroadhesive sections (14) are arranged such that the mounting surface (12) is divided into several holding zones (52, 62), wherein each holding zone (52, 62) is assigned a spacing gap (16) which adjoins at least one electroadhesive section (14) associated with the respective holding zone (52, 62).

11. Gripper apparatus according to one of the preceding claims, **characterised in that** the gripper apparatus is designed such that a controllable current can be passed through at least one electrode of an electroadhesive section.

12. Gripper apparatus according to claim 11, **characterised in that** at least one electroadhesive section is designed such that the associated electroadhesive section can be heated by means of the controllable current which can be passed through the associated electrode.

## Revendications

1. Dispositif de préhension (10, 30, 40, 50, 60, 70, 80) permettant de saisir et de maintenir des objets (2) comprenant une surface de réception (12) qui est orientée pour saisir un objet (2) et un agencement de préhension électro-adhésif comprenant au moins un segment d'électro-adhésion (14, 14') muni d'au moins une électrode (18) permettant d'exercer une force d'électro-adhésion sur l'objet (2), le segment d'électro-adhésion (14, 14') dépassant de la surface de réception (12) en direction de l'objet (2) à saisir pour lui permettre de s'appliquer sur cet objet de façon à former un espacement (16) contigu à la surface de réception (12) et au segment d'électro-adhésion (14, 14') le segment d'électro-adhésion (14, 14') étant déformable de façon à pouvoir s'adapter à la forme de l'objet (2) à saisir lors de son application sur cet objet,
**caractérisé en ce qu'**
il est prévu au moins un autre agencement de préhension (20) indépendant de l'électro-adhésion qui est situé sur un segment de la surface de réception (12) contigu à l'espacement (16).

2. Dispositif de préhension (10, 30, 40, 50, 60, 70, 80) conforme à la revendication 1,
**caractérisé en ce que**
l'autre agencement de préhension (20) est réalisé sous la forme d'un organe de préhension à ventouses (22) d'un organe de préhension de Bernoulli, d'un organe de préhension magnétique ou d'un organe de préhension à aiguilles (84).

3. Dispositif de préhension conforme à la revendication 1 ou 2,
**caractérisé en ce qu'**
il est prévu un agencement de séparation permettant d'exercer une force de séparation pour permettre de séparer un objet maintenu (2) du segment d'électro-adhésion (14), l'agencement de séparation étant en particulier monté sur un segment de la surface de réception (12) contigu à l'espacement (16).

4. Dispositif de préhension (60, 70, 80) conforme à l'une des revendications précédentes,
**caractérisé en ce que**
le segment d'électro-adhésion (14, 14') entoure totalement l'espacement (16) dans des directions s'étendant le long de la surface de réception (12).

5. Dispositif de préhension (70) conforme à l'une des revendications précédentes,
**caractérisé en ce que**
la surface de réception (12) est montée sur un corps d'aspiration (72) d'un organe de préhension à ventouses.

6. Dispositif de préhension (70) conforme à l'une des revendications précédentes,
**caractérisé en ce que**
le segment d'électro-adhésion (14, 14') est réalisé sous la forme d'une lèvre d'étanchéité de sorte qu'un volume d'aspiration du corps d'aspiration (72) puisse être rendu étanche lorsqu'un objet est appliqué.

7. Dispositif de préhension conforme à l'une des revendications précédentes,
**caractérisé en ce que**
le segment d'électro-adhésion (14) comprend un volume de remplissage entouré par des parois déformables qui est rempli d'un granulé, d'un fluide électro-rhéologique ou d'un fluide magnéto-rhéologique.

8. Dispositif de préhension conforme à l'une des revendications précédentes,
**caractérisé en ce que**
le segment d'électro-adhésion (14) peut être fixé de manière amovible sur la surface de réception (12).

9. Dispositif de préhension (30, 50, 60) conforme à l'une des revendications précédentes,
**caractérisé en ce qu'**
il est prévu un ensemble de segments d'électro-adhésion (14, 14') séparés qui peuvent être indépendamment les uns des autres activés pour exercer une force d'électro-adhésion et désactivés.

10. Dispositif de préhension (50, 60) conforme à l'une des revendications précédentes,
**caractérisé en ce que**
les segments d'électro-adhésion (14) sont positionnés de sorte que la surface de réception (12) soit subdivisée en plusieurs zones de retenue (52, 62), à chaque zone de retenue (52, 62) étant associé un espacement (16) qui est contigu à au moins l'un des segments d'électro-adhésion (14) associé aux zones de retenue (52, 62) respectives.

11. Dispositif de préhension conforme à l'une des revendications précédentes,
**caractérisé en ce qu'**
il est réalisé de sorte qu'au moins une électrode d'un segment d'électro-adhésion permette de fournir un courant commandable.

12. Dispositif de préhension conforme à la revendication 11,
**caractérisé en ce qu'**
au moins un segment d'électro-adhésion est réalisé de sorte que, le courant commandable pouvant être fourni par l'électrode associée, permette de chauffer le segment d'électro-adhésion associé.
